# EUROPEAN PATENT APPLICATION

(11) **EP 2 339 614 A1**
(43) Date of publication of application: **29.06.2011**
(21) Application number: 09180391.6
(22) Date of filing: 22.12.2009
(51) Int. Cl.: H01L 21/68, H01L 21/98, H01L 25/065, H01L 21/78

(54) **Method for stacking semiconductor chips**

(71) Applicant: IMEC, 3001 Leuven (BE)
(72) Inventor: Phommahaxay, Alain, 3000, LEUVEN (BE); Bogaerts, Lieve, 3460, BEKKEVOORT (BE); Buisson, Thibault, 3001, LEUVEN (BE); Van Cauwenberghe, Marc, 9810, NAZARETH (BE); Tutunjyan, Nina, 3000, LEUVEN (BE); Tilmans, Hendrikus, 3630, MAASMECHELEN (BE); Iker, François, 1435, MONT-SAINT-GUIBERT (BE); Joudain, Anne, 1390, GREZ-DOICEAU (BE)
(74) Representative: pronovem

(57) **Abstract**

The invention is related to a method for producing at least one semiconductor device, wherein a device wafer (1) is temporarily bonded to a support substrate (2), thinned and singulated to form separate dies (D1 to Dn). The dies, while remaining attached to the support substrate are then simultaneously attached to a target wafer (3), after which the support substrate (2) is removed. The above steps may be repeated to form stacks of dies. The target wafer is singulated to form said at least one device.

## Description

### Field of the Invention

The present invention is related to 3D integration and packaging technology, in particular to methods of dicing (singulating of dies) and stacking dies (chips).

### State of the art.

In presently known processes for die singulation and 3D integration, the wafer is thinned down on a temporary carrier and then the wafer-carrier assembly is singulated into dies, which are then stacked on a second wafer after which the carrier is finally removed. This process is very time-consuming since die stacking is done sequentially i.e. one die at the time. Furthermore die size is limited to some extent and can not be infinitely scaled down.

Other state of the art processes use wafer level bonding before die singulation. For example in document KR20080006299, a first chip wafer is bonded to a second chip wafer before dicing. In this type of technique, there is a lower limit to the thickness of the first chip wafer: below a given value, the first chip wafer cannot be deposited onto the second chip wafer, because it becomes impossible to handle such thin wafers mechanically.

### Summary of the invention

The present invention is related to a method as disclosed in the appended claims. The present invention is related to a method for producing at least one semiconductor device, comprising the steps of :
● Providing a device wafer having a front surface and a back surface,
● Providing a mechanical support substrate,
● Temporarily bonding the device wafer to the mechanical support substrate, by applying a releasable bonding means between the front surface of the device wafer and a surface of the support substrate,
● Thinning the device wafer, while the device wafer remains attached to the support substrate, thereby obtaining a thinned device wafer,
● Singulating the thinned device wafer to form separate chips (hereafter called dies), while the device wafer and ultimately the separate dies remain attached to the support substrate the separate dies having front sides attached to the support substrate and back sides,
● Attaching the dies simultaneously to a target wafer, while the dies remain attached to the support substrate, by bonding the backsides of the dies simultaneously to a surface of said target wafer,
● Removing the support substrate,
● Optionally, repeating the previous steps on one or more additional device wafers, to thereby obtain on the target wafer stacks of dies on top of said previously attached dies,
● Singulating the target wafer so as to obtain said at least one semiconductor device.

Said dies may be attached to said target wafer or to said previously attached dies by metallic bonding or polymer bonding. The method may further comprise a semiconductor processing step, after the thinning step and before the step of singulating the thinned device wafer.

The invention represents a considerable improvement over the existing technology. One major advantage is the fact that it is much easier and time saving to align a wafer containing the individual dies onto a target wafer (which can contain also individual dies which need to be aligned when stacking) than it is to align individual dies to each other. Also, because all the dies remain attached to a support substrate until they are attached to the target wafer, the dies can be thinned to lower thicknesses than is currently possible.

### Brief description of the figures

Figure 1 illustrates the various steps of a method of the invention.

Figure 2 illustrates the stacking of a plurality of dies according to the method of the invention.

### Detailed description of preferred embodiments of the invention

The invention is related to a method for producing at least one semiconductor device, wherein a device wafer is temporarily bonded to a support substrate, thinned and singulated to form separate dies. The dies, while remaining attached to the support substrate are then simultaneously attached to a target wafer, after which the support substrate is removed. The above steps may be repeated to form stacks of dies. The target wafer is singulated to form said at least one device.

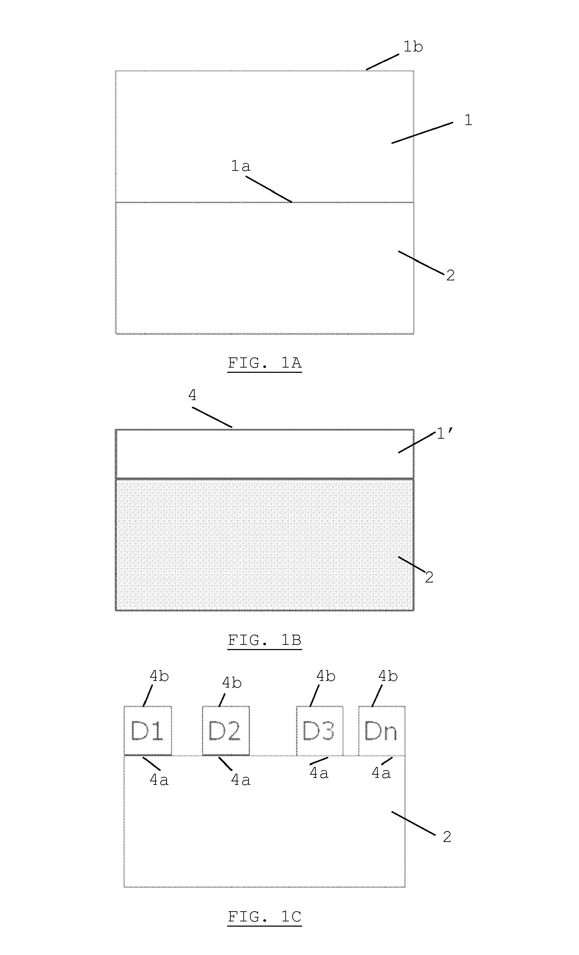

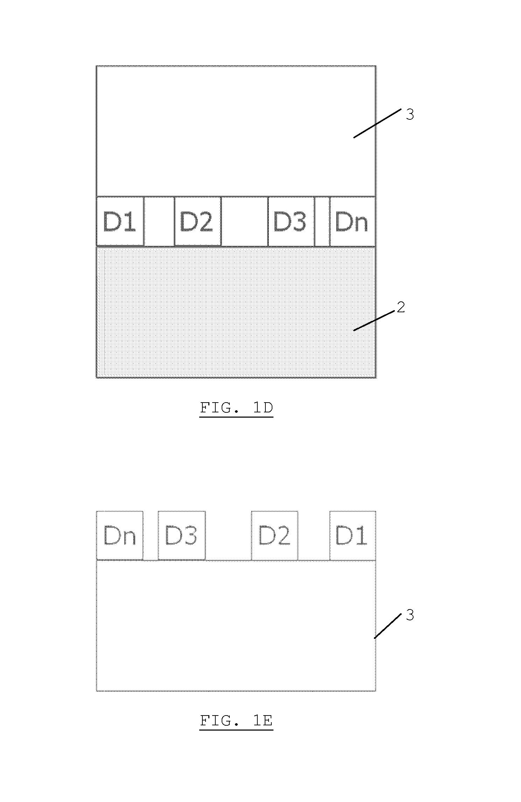

Figure 1 illustrates the basic method steps of the method of the invention, as disclosed in appended claim 1. Hereafter, possible ways of bringing these steps into practice are described in more detail. As shown in figure 1, the method of the invention comprises the following steps :
● Providing a device wafer 1 having a front surface 1a and a back surface 1b. A device wafer is defined as a (semiconductor) substrate comprising semiconductor components and/or circuitry (CMOS, MEMS, etc..) on said front surface,
● Providing a mechanical support substrate 2, e.g. a semiconductor wafer or an electrostatic chuck,
● Temporarily bonding the device wafer 1 to the mechanical support substrate 2, by applying a releasable bonding means between the front surface of the device wafer and a surface of the support substrate. The bonding means can e.g. be a glue that allows sliding of two wafers, or a glue that can be released by thermal decomposition, or by peeling off (fig. 1A).
● Thinning the device wafer 1 (fig. 1B). This step may for example be performed by a Chemical Mechanical Polishing (CMP) operation, possibly preceded by a grinding step, (the grinding step utilising suitable rough materials to remove e.g. 90 - 95% of the material to be removed, the actual CMP utilizing wet chemicals (slurries) to obtain a smooth surface). Alternatively, the thinning may be done by wet etching, possibly preceded by dry etching. The thinning is performed while the device wafer remains attached to the support substrate 2, thereby obtaining a thinned device wafer 1' having a front side 1a and a back side 4. After thinning, the device wafer may optionally be processed. For example, through wafer vias may be produced in this step.
● Singulating the thinned device wafer to form separate dies D1 to Dn, having front surfaces 4a and back surfaces 4b, while the device wafer and ultimately the separate dies remain attached to the support substrate 2 (fig. 1C). This step can e.g. be done by a plasma etch after a lithography step, or by saw dicing, or by laser dicing.
● Attaching all the dies D1 to Dn simultaneously to a target wafer 3, while the dies remain attached to the support substrate 2, by bonding the backsides 4b of the dies simultaneously to a surface of said target wafer (fig. 1D). The target wafer 3 may e.g. be a printed circuit board, or any suitable (device) substrate.
● Removing the support substrate 2. The removal technique depends on the type of temporary bonding means. For example when a glue is used that becomes more liquid when heated, the support can be removed by heating the glue layer and sliding off, i.e. the support wafer 2 is removed by a movement parallel to the plane of the support and target wafers. Alternatively, a glue can be used which decomposes when subjected to a UV treatment, thereby losing its adhesive properties.

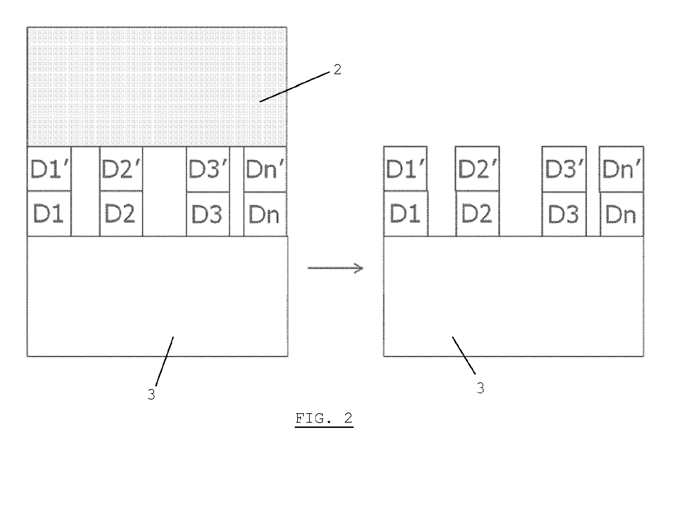

The above steps can be repeated to singulate a second series of dies D1' to Dn', whereby the backside of the dies D1' to Dn' is attached to the previously attached set of dies D1 to Dn on the target wafer, thus leading to stacks of two dies, as shown in figure 2. Before bonding, the substrates are aligned according to a known technique, e.g. under high vacuum in a wafer bonding tool, or by Anodic Bonding (wafers to bonded are heated in a process chamber). These steps can be again repeated any suitable number of times, to obtain stacks of several dies on the target wafer. When the stacks are complete (or after bonding of the first set of dies, in case the final devices comprise only one die), the target wafer is singulated by a suitable technique to obtain separate semiconductor devices.

The bonding between the dies and the target wafer 3 and/or between two dies (e.g. D1 and D1') may take place by _{:}
- Metallic bonding (Cu-Cu, Cu/Sn, Au-Au,...)
- Polymer bonding (BCB, RH8023,...)
- Hybrid bonding (polymer + metal)
- Direct bonding (Si-Si,...)
- Other.

The bonding between dies, e.g. D1 and D1', or between the target wafer and the first set of dies, may be done using state of the art micro-bumps (e.g. CuSn microbumping). This technology, similar to flip-chip interconnects, allows for high density interconnects. Only a thin layer of solder metal (or alloy) is used and upon assembly, the solder and the under-bump-metal (UBM) are completely transformed into an intermetallic compound. For specific applications (e.g. DRAM-stacking), the temperature budget for CuSn-based bumping may not be compatible with device imposed constraints. For these temperature sensitive applications, a die-level CuSn bonding process at a bonding temperature of only 150°C is possible.

The baseline Cu-Cu bonding process consists of a wet surface treatment followed by a thermocompression bonding step. A pure Cu-Cu thermocompression bonding process cannot be scaled to temperatures below 300°C, which has to be taken into account when choosing e.g. the glue material.

Another option is to incorporate a polymer dielectric layer in between the dies to stack, or between the target wafer and the first set of dies. This is a fast, low-temperature method which is also cost effective.

### Example : Process flow for MEMS packaging

The example below is explained using Figures 1 and 2. First of all a temporary commercially available glue, e.g. QS135 or HT10.10, is initially spun on a Si support substrate (2), a Si wafer. As illustrated Fig 1A, the device wafer (1) comprising MEMS devices is assembled to the support substrate (2) in a wafer bonder. The active side (1a) is in this case in contact with the glue layer. As illustrated in Fig 1B, the device wafer (1) is thinned down using a grinder down to 250µm, thus the initial backside (1b) of the device is removed. A new backside surface (4) of the thinned device wafer (1') can then be further processed.

As illustrated in Fig 1C, after a lithography step on the surface (4), it is possible to singulate the device wafer (1') into a various number of dies D1-Dn using a Deep Silicon Etch process. After stripping away the photoresist, it is possible to perform another lithographic step to provide the individual dies on their back surface 4b with a photosensitive polymer which acts as a permanent glue, BCB in the present example.

As illustrated in Fig 1D, a target wafer for containing the MEMS devices can then be assembled with the singulated dies. The two wafers (2+(D1-Dn)) and (3) are first aligned in a wafer bonder and then brought into contact. By applying pressure and heat, the BCB layer is cured at 250°C and the dies (D1-Dn) are then permanently bonded to the target wafer (3) with the back surfaces of the individual dies (4b). As illustrated in Fig 2E, the support (2) is removed, in the case of QS135, by chemical dissolution in acetone.

## Claims

1. A method for producing at least one semiconductor device, comprising the steps of :
● Providing a device wafer (1) having a front surface (1a) and a back surface (1b),
● Providing a mechanical support substrate (2),
● Temporarily bonding the device wafer (1) to the mechanical support substrate (2), by applying a releasable bonding means between the front surface of the device wafer and a surface of the support substrate,
● Thinning the device wafer (1), while the device wafer remains attached to the support substrate (2), thereby obtaining a thinned device wafer (1'),
● Singulating the thinned device wafer to form separate dies (D1 to Dn), while the device wafer and ultimately the separate dies remain attached to the support substrate (2), the separate dies having front sides (4a) attached to the support substrate (2) and back sides (4b),
● Attaching the dies (D1 to Dn) simultaneously to a target wafer (3), while the dies remain attached to the support substrate (2), by bonding the backsides (4b) of the dies simultaneously to a surface of said target wafer,
● Removing the support substrate (2),
● Singulating the target wafer (3) so as to obtain said at least one semiconductor device.

2. The method according to claim 1, wherein all of said steps except the step of singulating the target wafer (3) are repeated on one or more additional device wafers (1), and wherein the obtained dies are stacked on top of said previously attached dies (D1 to Dn), to form stacks of dies on the target wafer (3), and wherein said step of singulating the target wafer is performed after the formation of said stacks.

3. The method according to claim 1 or 2, wherein said dies are attached to said target wafer (3) or to said previously attached dies by metallic bonding or polymer bonding.

4. The method according to any one of claims 1 to 3, further comprising a semiconductor processing step, after the thinning step and before the step of singulating the thinned device wafer (1').
